(19) Europäisches Patentamt / European Patent Office / Office européen des brevets

(11) **EP 4 462 704 A1**

(12) **EUROPEAN PATENT APPLICATION**
published in accordance with Art. 153(4) EPC

(43) Date of publication:
**13.11.2024 Bulletin 2024/46**

(21) Application number: **23769535.8**

(22) Date of filing: **23.02.2023**

(51) International Patent Classification (IPC):
**H04L 1/00** *(2006.01)*

(52) Cooperative Patent Classification (CPC):
**H04L 1/00**

(86) International application number:
**PCT/CN2023/077792**

(87) International publication number:
**WO 2023/174027 (21.09.2023 Gazette 2023/38)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **14.03.2022 CN 202210247591**

(71) Applicant: **Huawei Technologies Co., Ltd.
Shenzhen, Guangdong 518129 (CN)**

(72) Inventors:
• **GUO, Wangmei**
 **Xi'an, Shaanxi 710068 (CN)**

• **GAO, Jingliang**
 **Xi'an, Shaanxi 710068 (CN)**
• **BIAN, Zhuolin**
 **Xi'an, Shaanxi 710068 (CN)**
• **LI, Yongkang**
 **Xi'an, Shaanxi 710068 (CN)**
• **CAI, Hua**
 **Shenzhen, Guangdong 518129 (CN)**
• **YU, Yichuan**
 **Shenzhen, Guangdong 518129 (CN)**
• **CHEN, Zhenyuan**
 **Shenzhen, Guangdong 518129 (CN)**

(74) Representative: **Körber, Martin Hans
Mitscherlich PartmbB
Patent- und Rechtsanwälte
Karlstraße 7
80333 München (DE)**

(54) **NETWORK CODING METHOD AND APPARATUS**

(57) Embodiments of this application disclose a network coding method and apparatus. The method includes: selecting a data packet group from a plurality of to-be-sent data packets; encoding the data packets by using a generator matrix, to generate an encoded data packet; and then sending the encoded data packet to a receiving end. Because the generator matrix is dimension-reduced from a multi-element field to a binary vector field, a calculation amount of the generator matrix is reduced, encoding and decoding complexity is reduced, and a data transmission delay is reduced.

FIG. 3

**Description**

This application claims priority to Chinese Patent Application No. CN202210247591.7, filed with the China National Intellectual Property Administration on March 14, 2022 and entitled "NETWORK CODING METHOD AND APPARATUS", which is incorporated herein by reference in its entirety.

**TECHNICAL FIELD**

Embodiments of this application relate to the communication field, and in particular, to a network coding method and apparatus.

**BACKGROUND**

In actual wireless communication, a wireless channel is affected by various factors, and a data packet may be lost in a channel transmission process. Two main methods for resolving a problem of a packet loss on a channel include an automatic repeat request (automatic repeat request, ARQ) and an erasure code (erasure code, EC). However, in the ARQ, feedback for each data packet occupies a network resource and has a delay. When channel performance is poor, extremely high overheads are caused by the feedback. In the erasure code such as a digital fountain code (digital fountain code, DF), reliable data transmission on a packet loss channel in a conventional wireless network can be ensured, but more coding redundancy is generated.

Currently, network coding allows a node to perform a forwarding operation after the node processes information received by the node. A node in a network has an encoding capability, and a receiving end performs decoding based on a correlation between encoded data packets. However, an encoding matrix used by a transmitting end to perform random linear network coding is a combination of an upper triangular matrix and a Vandermonde matrix. Linear independence between encoded data packets is ensured, but encoding and decoding complexity of the data packets is high, and an overall transmission delay is large.

Embodiments of this application provide a network coding method and apparatus, to reduce encoding and decoding complexity and reduce a transmission delay.

A first aspect of embodiments of this application provides a network coding method. The method includes: obtaining a data packet group in to-be-sent data packets, where the to-be-sent data packets include a plurality of data packet groups, and each data packet group includes a plurality of data packets; processing the data packet group based on a generator matrix of cyclic shift network coding, to generate encoded data packets, where an element included in the generator matrix is an element in a binary vector field converted from a multi-element field; and sending the encoded data packets to a receiving end.

In the foregoing aspect, an execution body is a transmitting end. The transmitting end may select the data packet group from the plurality of to-be-sent data packets; encode the data packets by using the generator matrix, to generate the encoded data packets; and then send the encoded data packets to the receiving end. Because the generator matrix is dimension-reduced from the multi-element field to the binary vector field, a calculation amount of the generator matrix is reduced, encoding and decoding complexity is reduced, and a data transmission delay is reduced.

In a possible implementation, the generator matrix is generated by expanding a low density parity check code (low density parity check code, LDPC) basis matrix.

In the foregoing possible implementation, an encoding and decoding delay is further reduced based on performance of low LDPC encoding and decoding complexity.

In a possible implementation, the method further includes: receiving a retransmission sequence number sent by the receiving end; and sending an encoded data packet corresponding to the retransmission sequence number to the receiving end.

In the foregoing possible implementation, when determining that an encoded data packet is lost, the receiving end may feed back a retransmission sequence number of the lost encoded data packet to the transmitting end, and the transmitting end may send an encoded data packet corresponding to the retransmission sequence number to the receiving end. This improves transmission quality.

In a possible implementation, after the receiving a retransmission sequence number sent by the receiving end, the method further includes: recording a quantity of retransmissions of the encoded data packet corresponding to the retransmission sequence number; and when the quantity of retransmissions is greater than a preset threshold, stopping retransmission of the encoded data packet corresponding to the retransmission sequence number.

In the foregoing possible implementation, the transmitting end may further record the quantity of retransmissions of the encoded data packet. When the quantity of retransmissions of the encoded data packet corresponding to the sequence number fed back by the receiving end is greater than the preset threshold, the transmitting end may stop retransmission, to avoid impact of continuous retransmission on the transmission delay.

In a possible implementation, the sending the encoded data packets to a receiving end in the foregoing step includes: when the plurality of data packet groups are all processed by using the generator matrix, sending the encoded data packets corresponding to the plurality of data packet groups to the receiving end.

In the foregoing possible implementation, the transmitting end sends the encoded data packets to the receiving end only after processing all the to-be-sent data packets to generate the encoded data packets.

A second aspect of embodiments of this application provides a network coding apparatus, to implement the method in any one of the first aspect or the possible implementations of the first aspect. The apparatus includes a corresponding unit or module configured to perform the method. The unit or the module included in the apparatus can be implemented by software and/or hardware. For example, the apparatus may be a network device, or may be a chip, a chip system, or a processor that supports the network device in implementing the foregoing method, or may be a logic module or software that can implement all or some functions of the network device.

A third aspect of embodiments of this application provides a computer device, including a processor. The processor is coupled to a memory. The memory is configured to store instructions. When the instructions are executed by the processor, the computer device is enabled to implement the method in any one of the first aspect or the possible implementations of the first aspect. For example, the computer device may be a network device, or may be a chip or a chip system that supports the network device in implementing the foregoing method.

A fourth aspect of embodiments of this application provides a computer-readable storage medium. The computer-readable storage medium stores instructions. When the instructions are executed by a processor, the method provided in any one of the first aspect or the possible implementations of the first aspect is implemented.

A fifth aspect of embodiments of this application provides a computer program product. The computer program product includes computer program code. When the computer program code is run on a computer, the method provided in any one of the first aspect or the possible implementations of the first aspect is implemented.

## BRIEF DESCRIPTION OF DRAWINGS

FIG. 1 is a diagram of a data packet transmission architecture according to an embodiment of this application;
FIG. 2 is a diagram of a manner of deploying cyclic shift network coding on a base station according to an embodiment of this application;
FIG. 3 is a schematic flowchart of a network coding method according to an embodiment of this application;
FIG. 4 is a schematic flowchart of sending data by a transmitting end according to an embodiment of this application;
FIG. 5 is a diagram of a structure of a network coding apparatus according to an embodiment of this application; and
FIG. 6 is a diagram of a structure of a computer device according to an embodiment of this application.

## DESCRIPTION OF EMBODIMENTS

Embodiments of this application provide a network coding method and apparatus, to reduce encoding and decoding complexity and reduce a transmission delay.

The following describes embodiments of this application with reference to the accompanying drawings. It is clear that the described embodiments are merely some rather than all of embodiments of this application. A person of ordinary skill in the art may learn that, with development of technologies and emergence of a new scenario, technical solutions provided in embodiments of this application are also applicable to a similar technical problem.

In the specification, the claims, and the accompanying drawings of this application, the terms "first", "second", and the like are intended to distinguish between similar objects but do not necessarily indicate a specific order or sequence. It should be understood that the data termed in such a way are interchangeable in appropriate cases so that embodiments described herein can be implemented in other orders than the order illustrated or described herein. In addition, the terms "include" and "have" and any other variants thereof are intended to cover a non-exclusive inclusion. For example, a process, a method, a system, a product, or a device that includes a list of steps or units is not necessarily limited to those expressly listed steps or units, but may include other steps or units not expressly listed or inherent to such a process, method, product, or device.

The specific term "example" herein means "used as an example, embodiment or illustration". Any embodiment described as an "example" is not necessarily explained as being superior to or better than other embodiments.

In addition, to better describe this application, numerous specific details are given in the following specific implementations. A person skilled in the art should understand that this application can also be implemented without some specific details. In some examples, methods, means, elements, and circuits that are well-known to a person skilled in the art are not described in detail, so that the subject matter of this application is highlighted.

First, some concepts provided in embodiments of this application are described.

Galois field (Galois field, GF)

The Galois field is GF($p^w$), where p is a prime number, and is usually set to 2. To ensure a unit element property, for addition and multiplication operations, GF($2^w$) uses polynomial operations instead of common addition and multiplication operations.

Particularly, when GF($2^1$)=GF(2), because a field includes only two elements, the field is generally referred to as a binary field. Other fields are referred to as multi-element fields. For example, GF($2^w$) is a finite field including $2^w$ elements. $(\cdot)^{-1}$ represents matrix inversion, and $(\cdot)^T$ represents transposition.

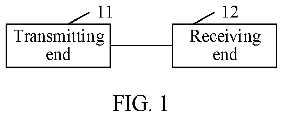

FIG. 1 is a diagram of a data packet transmission architecture according to an embodiment of this application. The architecture includes a transmitting end 11 and a receiving end 12. A data packet is generated and sent by the transmitting end 11, passes through a wireless channel with a specific erasure probability, and finally arrives at the receiving end 12 in a wireless network. The transmitting end 11 encodes the data packet after obtaining the data packet, to be specific, encodes a character, a digit, or another object into a digital code by using a pre-specified method, or converts information or data into a specified electrical pulse signal, where the electrical pulse signal is an encoded data packet. The transmitting end 11 may send the encoded data packet to the receiving end 12, and the receiving end 12 decodes the encoded data packet into original information based on a corresponding method after receiving the encoded data packet. The encoding method may be cyclic shift network coding, and an encoding operation is introduced into a network intermediate node, to improve a throughput, reliability, and security of network transmission, and reduce a transmission delay.

This embodiment of this application may be applied to a single-hop network, a wireless relay multi-hop network, point-to-point multipath transmission, or a satellite relay network. This is not limited herein.

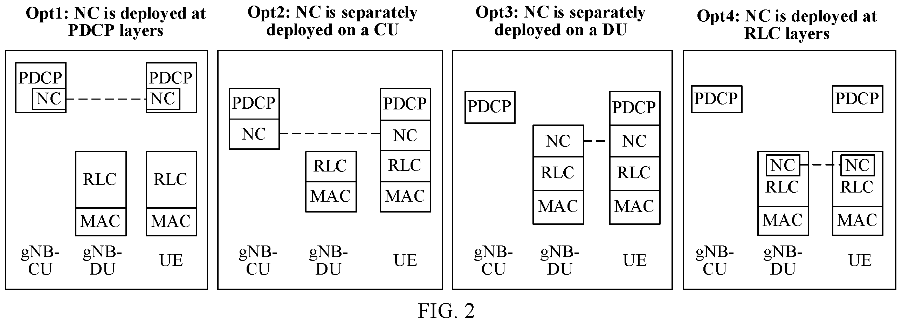

A CU-DU system architecture in a new radio (new radio, NR) protocol is used as an example. Refer to FIG. 2. The system architecture includes a next generation NodeB (next generation NodeB, gNB) or a next generation evolved NodeB (next generation evolved NodeB, ng-eNB). The gNB is used as an example. User equipment (user equipment, UE) may communicate with the gNB. The gNB may include one central unit (central unit, CU) and one or more distributed units (distributed units, DUs). One CU may be connected to one or more DUs. Only one CU and one DU are shown in the figure.

A packet data convergence protocol (packet data convergence protocol, PDCP) layer is deployed on the CU and the UE. A radio link control (radio link control, RLC) protocol layer and a media access control (media access control, MAC) layer are deployed on the DU and the UE.

PDCP function: A main purpose is to send or receive grouped data of a peer PDCP entity. A sublayer mainly implements the following several functions: internet protocol (internet protocol, IP) header compression and decompression, data and signaling encryption, and signaling integrity protection.

RLC function: A sublayer mainly provides a radio link control function, and provides services such as segmentation, retransmission control, and on-demand transmission for an upper layer.

A higher physical layer, the MAC layer, and the RLC layer that have a high requirement on real-time performance are deployed on the DU for processing, and the PDCP layer that has a low requirement on real-time performance is deployed on the CU for processing.

Cyclic shift network coding (network coding, NC) may be deployed on the gNB in a plurality of manners, as shown in FIG. 2: 1. The NC may be deployed at the PDCP layers of the CU and the UE. 2. The NC may be separately deployed on the CU and the UE. 3. The NC may be separately deployed on the DU and the UE. 4. The NC may be deployed at the RLC layers of the DU and the UE. This is not limited in embodiments of this application.

In actual wireless communication, a wireless channel is affected by various factors, and a data packet may be lost in a channel transmission process. Two main methods for resolving a problem of a packet loss on a channel include an automatic repeat request (automatic repeat request, ARQ) and an erasure code (erasure code, EC). However, in the ARQ, feedback for each data packet occupies a network resource and has a delay. When channel performance is poor, extremely high overheads are caused by the feedback. In the erasure code such as a digital fountain code (digital fountain code, DF), reliable data transmission on a packet loss channel in a conventional wireless network can be ensured, but more coding redundancy is generated. Network coding actually allows a node to perform a forwarding operation after the node processes information received by the node. Because a node in a network has an encoding capability, and a receiving end performs decoding based on a correlation between encoded data packets, a decoding success rate is greatly improved, coding redundancy and a quantity of data packet retransmissions are reduced, and a network throughput is improved. However, an encoding matrix used by a transmitting end to perform random linear network coding is a combination of an upper triangular matrix and a Vandermonde matrix. Although linear independence between encoded data packets is ensured, encoding and decoding complexity is high, and an overall transmission delay is large.

To resolve the foregoing problem, an embodiment of this application provides a network coding method. The method is described as follows:

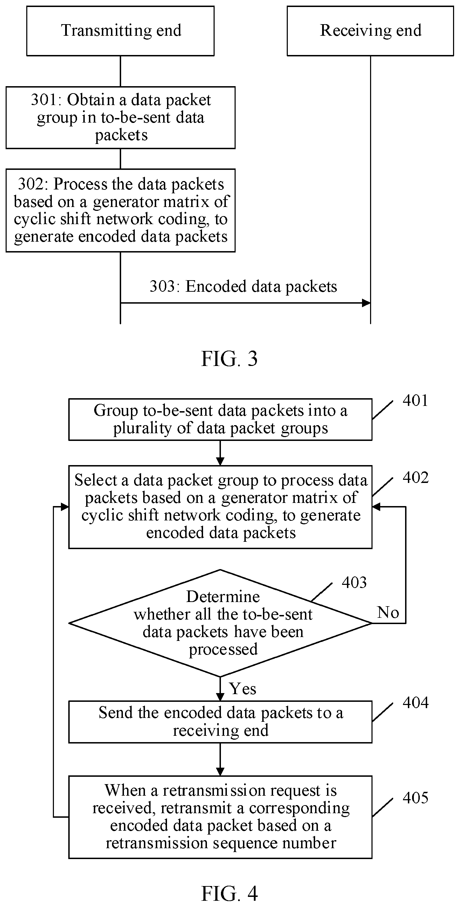

FIG. 3 is a diagram of a network coding method according to an embodiment of this application. The method includes the following steps.

Step 301: A transmitting end obtains a data packet group in to-be-sent data packets.

In this embodiment, data packets in the data packet group may be generated by the transmitting end, or may be generated and transmitted to the transmitting end by a previous node. When the data packets are generated by the transmitting end, the transmitting end may directly obtain the data packets locally. When the data packets are sent by the previous node, the data packets are obtained by the transmitting end by receiving the data packets. The to-be-sent data packets include a plurality of data packet groups, and each data packet group includes a plurality of data packets.

Step 302: The transmitting end processes the data packets based on a generator matrix of cyclic shift network coding to generate encoded data packets, where an element included in the generator matrix is an element in a binary vector field converted from a multi-element field.

In this embodiment, information symbols in the foregoing data packets are all obtained from $GF(2^L)$, where L is an even number, and L is a prime number whose primitive element is 2. In this embodiment of this application, $GF(2^L)$ is a multi-element field. Because coding construction in the multi-element field increases encoding and decoding complexity, in this embodiment of this application, the multi-element field may be converted into a binary vector field GF(2). An element in the binary vector field is used as an element in the generator matrix of the cyclic shift network coding, and network coding in the binary field is constructed by using a cyclic shift structure characteristic of the cyclic shift network coding, so that a low-complexity shift operation is implemented while approximate performance of network coding in the $GF(2^L)$ multi-element field is achieved. In other words, low encoding and decoding complexity is achieved, encoding and decoding time is reduced, and a transmission delay is reduced.

Specifically, after obtaining the data packets, the transmitting end evenly groups all the to-be-sent data packets into groups that each includes k data packets, and uses all-zero packets to supplement data packets that finally cannot be grouped, where a value of k ranges from 1 to a total quantity of all to-be-sent data packets.

For each data packet group, the transmitting end may expand a group of packets to $N = \left\lceil \dfrac{k}{1-\varepsilon} \right\rceil + a$ packets, and add obtained encoded data packets to a send queue of the transmitting end, where $\lceil \cdot \rceil$ represents a ceiling operation, and $\varepsilon$ represents an erasure probability of a channel in a wireless network selected within a range [0, 0.9]. It can be learned through calculation that, for a receiving end to receive and decode a group of packets, an average value of quantities of packets that the transmitting end needs to send is at least $\left\lceil \dfrac{k}{1-\varepsilon} \right\rceil$. a indicates an expansion margin, and can be dynamically adjusted based on system requirements for indicators such as reliability and a packet delay.

In this embodiment, the generator matrix of the cyclic shift network coding may be further obtained by expanding a low density parity check code (low density parity check code, LDPC) basis matrix (where the generator matrix may alternatively be replaced by another decoding algorithm, and an LDPC is used as an example in this embodiment of this application), so that an encoding and decoding delay is reduced based on performance of low LDPC encoding and decoding complexity.

Specifically, an LDPC coding solution is randomly selected to obtain a check matrix $H_{(N'-k) \times N'}$ of the LDPC coding solution, and then a basis matrix $G_{k \times N'}$ is obtained based on the check matrix. All elements in the matrix are obtained from GF(2). $N' > N$. In this case, after the transmitting end sends N packets for the first time, sufficient column vectors are still left in $G_{k \times N'}$ as encoding coefficients to generate retransmission packets.

$C_{L+1}$ is denoted as a cyclic shift matrix $\begin{bmatrix} 0 & I_L \\ 1 & 0 \end{bmatrix}$, where $I_L$ is a unit matrix whose length of each row and length of each column are L, and for a binary sequence $m$ whose length is $L + 1$, a linear combination $mC_{L+1}^l (1 \leq l \leq L+1)$ is obtained by cyclically shifting $m$ rightward by l bits. An L × (L + 1) matrix $G$ and an (L + 1) × L matrix $H$ in a binary field are defined as follows:

$$G = [I_L \quad 1], \text{ and } H = [I_L \quad 1]^T.$$

A set is denoted as follows:

$$Cs = \{O, GC_{L+1}H, GC_{L+1}^2 H, GC_{L+1}^3 H, \cdots, GC_{L+1}^{L+1} H\}.$$

$$GC_{L+1}^{L+1}H = I_L$$ . In this way, a cyclic shift coefficient matrix set C is obtained.

Each element in an LDPC basis matrix $G_{k \times N'}$ may be replaced with a matrix in the set Cs according to the following rule, to obtain a generator matrix $\hat{G}_{kL \times N'L}$ of the cyclic shift network coding, and $\hat{G}_{kL \times N'L}$ is actually a block matrix. Assuming that $\Gamma_{i,j}$ represents a coefficient matrix in an $i^{th}$ row and a $j^{th}$ column in $\hat{G}_{kL \times N'L}$, and $g_{i,j}$ represents a coefficient in an $i^{th}$ row and a $j^{th}$ column in $G_{k \times N'}$,

$$\Gamma_{i,j} = \begin{cases} 0 & g_{i,j} = 0 \\ 1 & g_{i,j} = 1, j \leq k \\ \text{Any non-zero matrix in } Cs & g_{i,j} = 0, j > k \end{cases}.$$

A block matrix in a $j^{th}$ column in $\hat{G}_{kL \times N'L}$ corresponds to an encoding coefficient matrix of a $j^{th}$ data packet. During the first time of sending by the transmitting end, the first k data packets are original data packets $m_i$, and in corresponding encoding coefficient matrices $G_j$, only a $j^{th}$ block is a unit matrix, and the rest are all zero matrices. Subsequent N-K data packets are all encoded data packets, and are generated by using a block matrix

$$G_{k+d} = \left[ \Gamma_{1,k+d}^T, \Gamma_{2,k+d}^T, \cdots, \Gamma_{k,k+d}^T \right]^T$$ in a $(k + d)^{th}$ column in $\hat{G}_{kL \times N'L}$ as a coefficient. These encoded data packets may be obtained based on $m_{k+d} = \sum_{i=1}^{k} \Gamma_{i,k+d} \circ m_i$ through calculation, where $1 \leq i \leq k$, and $1 \leq d \leq N - k$.

For $\Gamma \in Cs$, $\Gamma \circ m_i$ represents a linear combination of an encoding coefficient matrix and a data packet, and is defined as follows: A packet $m_i$ including M bits ( $\frac{M}{L}$ $GF(2^L)$ symbols) may be expressed as a row vector $\left[ s_{i,1}, s_{i,2}, \cdots, s_{i,\frac{M}{L}} \right]$, where each row vector $s_{i,k}$ is a row vector that is in GF(2) and whose length is L, and the encoded

data packet is $\Gamma \circ m_j = \left[ s_{i,1}\Gamma, s_{i,2}\Gamma, \cdots, s_{i,\frac{M}{L}}\Gamma \right]$.

For example, it is assumed that a group of k=7 original data packets need to be sent, the seven original data packets each include four symbols in $GF(2^3)$, that is, 12 bits, and a string of 3 bits converted from a $j^{th}$ symbol of an $i^{th}$ packet is expressed as $s_{ij}$. In this case,

$$m_1 = [010 \quad 110 \quad 101 \quad 110] = [s_{11} \quad s_{12} \quad s_{13} \quad s_{14}];$$

$$m_2 = [010 \quad 110 \quad 101 \quad 110] = [s_{21} \quad s_{22} \quad s_{23} \quad s_{24}];$$

$$m_3 = [010 \quad 110 \quad 101 \quad 110] = [s_{31} \quad s_{32} \quad s_{33} \quad s_{34}];$$

$$m_4 = [010 \quad 110 \quad 101 \quad 110] = [s_{41} \quad s_{42} \quad s_{43} \quad s_{44}];$$

$$m_5 = [010 \quad 110 \quad 101 \quad 110] = [s_{51} \quad s_{52} \quad s_{53} \quad s_{54}];$$

$$m_6 = [010 \quad 110 \quad 101 \quad 110] = [s_{61} \quad s_{62} \quad s_{63} \quad s_{64}];$$

and

$$m_7 = [010 \quad 110 \quad 101 \quad 110] = [s_{71} \quad s_{72} \quad s_{73} \quad s_{74}].$$

This group of packets are encoded into N=11packets (where $N = \left\lceil \frac{k}{1-\varepsilon} \right\rceil$ , and $\varepsilon = 0.35$) based on a systematic code, that is, the first seven packets are original packets, and the last four packets are encoded data packets. It is assumed that:

$$G = \begin{bmatrix} 1 & 0 & 0 & 1 \\ 0 & 1 & 0 & 1 \\ 0 & 0 & 1 & 1 \end{bmatrix}, \; H = \begin{bmatrix} 1 & 0 & 0 & 1 \\ 0 & 1 & 0 & 1 \\ 0 & 0 & 1 & 1 \end{bmatrix}^T, \; \text{and} \; C_{L+1} = \begin{bmatrix} 0 & 1 & 0 & 0 \\ 0 & 0 & 1 & 0 \\ 0 & 0 & 0 & 1 \\ 1 & 0 & 0 & 0 \end{bmatrix}.$$

In this case, an encoding coefficient matrix set C may be obtained as follows:

$$Cs = \{O, GC_{L+1}H, GC_{L+1}^2 H, GC_{L+1}^3 H, \cdots, GC_{L+1}^{L+1}H\}$$

$$= \left\{ \begin{bmatrix} 0 & 0 & 0 \\ 0 & 0 & 0 \\ 0 & 0 & 0 \end{bmatrix}, \begin{bmatrix} 1 & 1 & 0 \\ 1 & 0 & 1 \\ 1 & 0 & 0 \end{bmatrix}, \begin{bmatrix} 0 & 1 & 1 \\ 0 & 1 & 0 \\ 1 & 1 & 0 \end{bmatrix}, \begin{bmatrix} 0 & 0 & 1 \\ 1 & 0 & 1 \\ 0 & 1 & 1 \end{bmatrix}, \begin{bmatrix} 1 & 0 & 0 \\ 0 & 1 & 0 \\ 0 & 0 & 1 \end{bmatrix} \right\}$$

$$= \{O, C_1, C_2, C_3, C_4\}.$$

An 8×15 LDPC check matrix H based on an improved PEJ algorithm is used as an example:

$$H = \begin{bmatrix} 0 & 0 & 0 & 1 & 0 & 0 & 0 & 1 & 0 & 1 & 0 & 1 & 0 & 0 & 1 \\ 0 & 0 & 1 & 0 & 1 & 0 & 0 & 0 & 0 & 1 & 0 & 0 & 1 & 0 & 0 \\ 0 & 0 & 1 & 0 & 0 & 1 & 1 & 0 & 0 & 0 & 0 & 1 & 0 & 0 & 1 \\ 0 & 1 & 0 & 0 & 0 & 1 & 0 & 0 & 0 & 0 & 1 & 0 & 1 & 0 & 0 \\ 0 & 1 & 0 & 0 & 0 & 0 & 0 & 0 & 1 & 0 & 0 & 1 & 0 & 1 & 0 \\ 0 & 0 & 0 & 1 & 1 & 0 & 0 & 0 & 0 & 0 & 1 & 0 & 0 & 1 & 1 \\ 1 & 0 & 0 & 0 & 0 & 0 & 0 & 0 & 1 & 1 & 1 & 0 & 0 & 0 & 0 \\ 1 & 0 & 0 & 0 & 0 & 0 & 1 & 1 & 0 & 0 & 0 & 0 & 1 & 1 & 0 \end{bmatrix}.$$

In addition, a corresponding basis matrix is obtained based on the check matrix:

$$G = \begin{bmatrix} 1 & 0 & 0 & 0 & 0 & 0 & 0 & 1 & 1 & 1 & 1 & 0 & 1 & 1 & 0 \\ 0 & 1 & 0 & 0 & 0 & 0 & 0 & 1 & 1 & 1 & 0 & 0 & 1 & 0 & 0 \\ 0 & 0 & 1 & 0 & 0 & 0 & 0 & 0 & 1 & 1 & 0 & 1 & 0 & 0 & 0 \\ 0 & 0 & 0 & 1 & 0 & 0 & 0 & 0 & 0 & 1 & 1 & 1 & 1 & 1 & 1 \\ 0 & 0 & 0 & 0 & 1 & 0 & 0 & 1 & 1 & 1 & 0 & 0 & 0 & 1 & 0 \\ 0 & 0 & 0 & 0 & 0 & 1 & 0 & 0 & 1 & 1 & 0 & 0 & 1 & 1 & 1 \\ 0 & 0 & 0 & 0 & 0 & 0 & 1 & 0 & 0 & 1 & 1 & 0 & 1 & 0 & 1 \end{bmatrix}.$$

The LDPC basis matrix is expanded to a generator matrix of cyclic shift vector network coding. An expanded matrix $\hat{G}_{21 \times 45}$ is not shown herein due to limited space. Based on the foregoing descriptions, the first seven data packets are original packets, and the last four packets are encoded data packets. A calculation formula is as follows:

$$m_i' = \sum_{i=1}^{7} \Gamma_{i,j} \circ m_i, 8 \leq j \leq 11.$$

An eighth packet is used as an example. It is assumed that an encoding coefficient matrix (a block matrix in an eighth column in $\hat{G}_{21 \times 45}$, which is written in a row form for convenience) of the eighth packet is as follows:

$$\begin{bmatrix} 1 & 1 & 0 & 0 & 1 & 1 & 0 & 0 & 0 & 0 & 0 & 0 & 0 & 1 & 1 & 0 & 0 & 0 & 0 & 0 & 0 \\ 1 & 0 & 1 & 0 & 1 & 0 & 0 & 0 & 0 & 0 & 0 & 0 & 0 & 1 & 0 & 0 & 0 & 0 & 0 & 0 & 0 \\ 1 & 0 & 0' & 1 & 1 & 0' & 0 & 0 & 0' & 0 & 0 & 0' & 1 & 1 & 0' & 0 & 0 & 0' & 0 & 0 & 0 \\ & \Gamma_{1,8} & & \Gamma_{2,8} & & \Gamma_{3,8} & & \Gamma_{4,8} & & \Gamma_{5,8} & & \Gamma_{6,8} & & \Gamma_{7,8} & & & & & & & \end{bmatrix}$$

In this case, an encoded data packet is obtained as follows:

$$m_8' = \sum_{i=1}^{7} \Gamma_{i,j} \circ m_i$$

$$= \Gamma_{1,8} \circ m_1 + \cdots + \Gamma_{7,8} \circ m_7$$

$$= [s_{11}\Gamma_{1,8}, s_{12}\Gamma_{1,8}, s_2\Gamma_{1,8}, s_{14}\Gamma_{1,8}] + \cdots + [s_{71}\Gamma_{7,8}, s_{72}\Gamma_{7,8}, s_{72}\Gamma_{7,8}, s_{74}\Gamma_{7,8}]$$

$$= [000, 101, 111, 111].$$

Step 303: The transmitting end sends the encoded data packets to the receiving end.

After generating the encoded data packets, the transmitting end may send the encoded data packets to the receiving end by using the send queue, so that the receiving end may decode the encoded data packets, to obtain the to-be-sent data packets.

Specifically, before sending the encoded data packets, the transmitting end may further determine whether all the data packet groups have been processed to generate encoded data packets. After all the data packet groups are processed, the transmitting end transmits the encoded data packets to the transmitting end one by one.

In this embodiment, a process of processing the encoded data packets by the receiving end may be: calculating a rank r of a coefficient matrix in one group of encoded data packets, and comparing a value of r with a value of kL. If r = kL, that is, an encoding coefficient matrix of the group of packets is full-rank, preliminary decoding may be performed on the received data packets by using an error back propagation (error back propagation, BP) algorithm.

The receiving end receives P (P>N) data packets, where an encoding coefficient matrix of the P data packets forms a kL × PL block matrix that is in GF(2) and whose rank is kL, and each column of the block matrix corresponds to encoding information of one data packet. In a condition of systematic encoding, U data packets in the group are original data packets received by the receiving end, and remaining P-U data packets are encoded data packets $m_{U+1}', \cdots$, and $m_P'$. The original data packets can be directly decoded. The encoded data packets may be expressed as $m_j' = \sum_{U+1 \leq j \leq P} \Gamma_{i,j} \circ m_i$, and an updated encoded data packet set is defined as $\Phi = \{m_{U+1}', \cdots, m_P'\}$. A coefficient matrix corresponding to each updated encoded data packet is reset to a (k-U)L×L matrix, and then coefficient matrices of all P-U encoded data packets are combined into a (P-U)L×(P-U)L block matrix, where $\Gamma_{i,j}$ represents an ith coefficient matrix in a coefficient matrix of an $(m_j')^{\text{th}}$ packet.

An encoded data packet $m_{j0}'$ whose coefficient matrix includes only one non-zero coefficient matrix $\Gamma_{i_0,j_0}$ (U+1≤i$_0$≤k) is selected from $\Phi$, and remaining packets in $\Phi$ are updated based on $m_{j_0} = \Gamma_{i_0,j_0}^{-1} \circ m_{j_0}'$ and $m_{j_0}' = m_j' - \Gamma_{i_0,j_0} \circ m_{j_0}$. In this case, a quantity of decoded packets is U≤U'≤k. Then, an encoding coefficient matrix corresponding to $m_{j_0}$ is deleted from a (k-U') × |$\Phi$|L block matrix, and this step is repeated until each encoded data packet in $\Phi$ is generated from at least two original packets.

If $\Phi$ is null or |$\Phi$| = 1, all packets are successfully decoded. Otherwise, each remaining data packet in $\Phi$ is a linear combination of at least two original packets. In this case, if |$\Phi$| > k-U', it indicates that there are still linearly correlated encoded data packets in $\Phi$, and after the linearly correlated encoded data packets are removed, |$\Phi$| = k - U'. Because the systematic encoding is used, after the foregoing several operations, a value of |$\Phi$| is greatly reduced, and a |$\Phi$|L × |$\Phi$|L block matrix formed by coefficients of |$\Phi$| encoded data packets is still a full-rank binary matrix. In this case, remaining encoded data packets may be directly decoded by using a Gaussian elimination method. At this point, decoding ends.

If the value of |$\Phi$| is still large after the foregoing steps, calculation complexity of directly using the Gaussian elimination method is $O(|\Phi|^3)$; and when decoding can be performed, complexity required for performing iterative decoding by directly using a check matrix of an LDPC matrix is $O(|\Phi|)$, and encoding and decoding complexity is low.

In this embodiment of this application, when determining that an encoded data packet is lost, the receiving end may feed back a retransmission sequence number of the lost encoded data packet to the transmitting end, and the transmitting end may send an encoded data packet corresponding to the retransmission sequence number to the receiving end. The transmitting end may further record a quantity of retransmissions of the encoded data packet. When the quantity of retransmissions of the encoded data packet corresponding to the sequence number fed back by the receiving end is greater than a preset threshold, the transmitting end may stop retransmission to avoid impact of continuous retransmission on a delay.

For example, the transmitting end obtains, in an encoding method of the generator matrix of the cyclic shift network coding, by using an unused block matrix in $\hat{G}_{kL \times N'L}$, an encoded data packet corresponding to a received retransmission sequence number, inserts the generated encoded data packet into the send queue of the transmitting end, and increases a quantity of retransmissions corresponding to the encoded data packet by 1.

For example, for steps of sending data by the transmitting end to the receiving end, refer to a schematic flowchart of sending data by the transmitting end shown in FIG. 4. Step 401: Group to-be-sent data packets into a plurality of data packet groups. Step 402: Select a data packet group to process data packets based on a generator matrix of cyclic shift network coding, to generate encoded data packets. Step 403: Determine whether all the to-be-sent data packets have been processed; and if all the to-be-sent data packets have been processed, perform step 404; otherwise, perform step 402. Step 404: Send the encoded data packets to the receiving end. Step 405: When a retransmission request is received, retransmit a corresponding encoded data packet based on a retransmission sequence number.

The foregoing describes the network coding method, and the following describes an apparatus for performing the method.

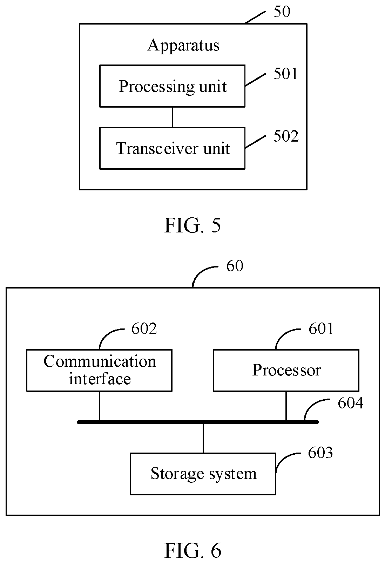

As shown in FIG. 5, an embodiment of this application provides a network coding apparatus. The apparatus 50 includes:

a processing unit 501, configured to: obtain a data packet group in to-be-sent data packets, where the to-be-sent data packets include a plurality of data packet groups, and each data packet group includes a plurality of data packets; and process the data packet group based on a generator matrix of cyclic shift network coding, to generate encoded data packets, where an element included in the generator matrix is an element in a binary vector field converted from a multi-element field; and
a transceiver unit 502, configured to send the encoded data packets to a receiving end.

Optionally, the generator matrix is generated by expanding a low density parity check code LDPC basis matrix.

Optionally, the transceiver unit 502 is further configured to: receive a retransmission sequence number sent by the receiving end; and send an encoded data packet corresponding to the retransmission sequence number to the receiving end.

Optionally, the processing unit 501 is further configured to: record a quantity of retransmissions of the encoded data packet corresponding to the retransmission sequence number; and when the quantity of retransmissions is greater than a preset threshold, stop retransmission of the encoded data packet corresponding to the retransmission sequence number.

Optionally, the transceiver unit 502 is specifically configured to: when the plurality of data packet groups are all processed by using the generator matrix, send encoded data packets corresponding to the plurality of data packet groups to the receiving end.

The processing unit 501 of the apparatus 50 is configured to perform step 301 and step 302 in the method embodiment in FIG. 3, and the determining unit 502 of the apparatus 50 is configured to perform step 303 in the method embodiment in FIG. 3. Details are not described herein again.

FIG. 6 is a diagram of a possible logical structure of a computer device 60 according to an embodiment of this application. The computer device 60 includes a processor 601, a communication interface 602, a storage system 603, and a bus 604. The processor 601, the communication interface 602, and the storage system 603 are connected to each other by using the bus 604. In this embodiment of this application, the processor 601 is configured to control and manage an action of the computer device 60. For example, the processor 601 is configured to perform the steps performed by the transmitting end in the method embodiment in FIG. 3. The communication interface 602 is configured to support the computer device 60 in performing communication. The storage system 603 is configured to store program code and data of the computer device 60.

The processor 601 may be a central processing unit, a general-purpose processor, a digital signal processor, an application-specific integrated circuit, a field programmable gate array or another programmable logic device, a transistor logic device, a hardware component, or any combination thereof. The processor may implement or execute various example logical blocks, modules, and circuits described with reference to content disclosed in this application.

Alternatively, the processor 601 may be a combination of processors implementing a computing function, for example, a combination including one or more microprocessors, or a combination of a digital signal processor and a microprocessor. The bus 604 may be a peripheral component interconnect (Peripheral Component Interconnect, PCI) bus, an extended industry standard architecture (Extended Industry Standard Architecture, EISA) bus, or the like. Buses may be classified into an address bus, a data bus, a control bus, and the like. For ease of indication, the bus is indicated by only one bold line in FIG. 6. However, it does not indicate that there is only one bus or only one type of bus.

The transceiver unit 502 in the apparatus 50 is equivalent to the communication interface 602 in the computer device 60, and the processing unit 501 in the apparatus 50 is equivalent to the processor 601 in the computer device 60.

The computer device 60 in this embodiment may correspond to a charging device in the method embodiment in FIG. 2. The communication interface 602 in the computer device 60 may implement functions of the charging device in the method embodiment in FIG. 2 and/or various steps implemented by the charging device in the method embodiment in FIG. 2. For brevity, details are not described herein again.

It should be understood that division of the units in the foregoing apparatus is merely logical function division. During actual implementation, all or some of the units may be integrated into one physical entity, or may be physically separated. In addition, all the units in the apparatus may be implemented in a form of software invoked by a processing element, or may be implemented in a form of hardware; or some units may be implemented in a form of software invoked by a processing element, and some units may be implemented in a form of hardware. For example, each unit may be a separately disposed processing element, or may be integrated into a chip of the apparatus for implementation. In addition, each unit may alternatively be stored in a memory in a form of a program to be invoked by a processing element of the apparatus to perform a function of the unit. In addition, all or some of the units may be integrated, or may be implemented independently. The processing element herein may also be referred to as a processor, and may be an integrated circuit having a signal processing capability. During implementation, steps in the foregoing methods or the foregoing units may be implemented by using a hardware integrated logic circuit in a processor element, or may be implemented in a form of software invoked by a processing element.

In an example, the unit in any one of the foregoing apparatuses may be one or more integrated circuits configured to implement the foregoing methods, for example, one or more application-specific integrated circuits (application-specific integrated circuits, ASICs), or one or more microprocessors (digital signal processors, DSPs), or one or more field programmable gate arrays (field programmable gate arrays, FPGAs), or a combination of at least two of these integrated circuit forms. For another example, when the unit in the apparatus is implemented in a form of scheduling a program by a processing element, the processing element may be a general-purpose processor, for example, a central processing unit (central processing unit, CPU) or another processor that can invoke the program. For still another example, the units may be integrated and implemented in a form of a system-on-a-chip (system-on-a-chip, SoC).

In another embodiment of this application, a computer-readable storage medium is further provided. The computer-readable storage medium stores computer-executable instructions. When a processor of a device executes the computer-executable instructions, the device performs the method performed by the transmitting end in the foregoing method embodiment.

In another embodiment of this application, a computer program product is further provided. The computer program product includes computer-executable instructions, and the computer-executable instructions are stored in a computer-readable storage medium. When a processor of a device executes the computer-executable instructions, the device performs the method performed by the transmitting end in the foregoing method embodiment.

It may be clearly understood by a person skilled in the art that, for the purpose of convenient and brief description, for a detailed working process of the foregoing system, apparatus, and unit, refer to a corresponding process in the foregoing method embodiment, and details are not described herein again.

In several embodiments provided in this application, it should be understood that the disclosed system, apparatus, and method may be implemented in other manners. For example, the described apparatus embodiment is merely an example. For example, division into the units is merely logical function division and may be other division during actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or the units may be implemented in electronic, mechanical, or other forms.

The units described as separate parts may or may not be physically separate, and parts displayed as units may or may not be physical units, may be located at one position, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units are integrated into one unit. The integrated unit may be implemented in a form of hardware, or may be implemented in a form of a software functional unit.

When the integrated unit is implemented in the form of the software functional unit and sold or used as an independent product, the integrated unit may be stored in a computer-readable storage medium. Based on such an understanding, the technical solutions of this application essentially, or the part contributing to the conventional technology, or all or some of the technical solutions may be implemented in the form of a software product. The computer software product is stored in a storage medium and includes several instructions for instructing a computer device (which may be a personal computer, a server, a network device, or the like) to perform all or some of the steps of the methods described in embodiments of this application. The foregoing storage medium includes any medium that can store program code, such as a USB flash drive, a removable hard disk, a read-only memory (ROM, read-only memory), a random access memory (RAM, random access memory), a magnetic disk, or an optical disc.

**Claims**

1. A network coding method, comprising:

   obtaining a data packet group in to-be-sent data packets, wherein the to-be-sent data packets comprise a plurality of data packet groups, and each data packet group comprises a plurality of data packets;
   processing the data packet group based on a generator matrix of cyclic shift network coding, to generate encoded data packets, wherein an element comprised in the generator matrix is an element in a binary vector field converted from a multi-element field; and
   sending the encoded data packets to a receiving end.

2. The method according to claim 1, wherein the generator matrix is generated by expanding a low density parity check code LDPC basis matrix.

3. The method according to claim 1 or 2, wherein the method further comprises:

   receiving a retransmission sequence number sent by the receiving end; and
   sending an encoded data packet corresponding to the retransmission sequence number to the receiving end.

4. The method according to claim 3, wherein after the receiving a retransmission sequence number sent by the receiving end, the method further comprises:

   recording a quantity of retransmissions of the encoded data packet corresponding to the retransmission sequence number; and
   when the quantity of retransmissions is greater than a preset threshold, stopping retransmission of the encoded data packet corresponding to the retransmission sequence number.

5. The method according to any one of claims 1 to 4, wherein the sending the encoded data packets to a receiving end comprises:
   when the plurality of data packet groups are all processed by using the generator matrix, sending encoded data packets corresponding to the plurality of data packet groups to the receiving end.

6. A network coding apparatus, comprising:

   a processing unit, configured to: obtain a data packet group in to-be-sent data packets, wherein the to-be-sent data packets comprise a plurality of data packet groups, and each data packet group comprises a plurality of data packets; and process the data packet group based on a generator matrix of cyclic shift network coding, to generate encoded data packets, wherein an element comprised in the generator matrix is an element in a binary vector field converted from a multi-element field; and
   a transceiver unit, configured to send the encoded data packets to a receiving end.

7. The apparatus according to claim 6, wherein the generator matrix is generated by expanding a low density parity check code LDPC basis matrix.

8. The apparatus according to claim 6 or 7, wherein the transceiver unit is further configured to:

   receive a retransmission sequence number sent by the receiving end; and

send an encoded data packet corresponding to the retransmission sequence number to the receiving end.

9. The apparatus according to claim 8, wherein the processing unit is further configured to:

record a quantity of retransmissions of the encoded data packet corresponding to the retransmission sequence number; and
when the quantity of retransmissions is greater than a preset threshold, stop retransmission of the encoded data packet corresponding to the retransmission sequence number.

10. The apparatus according to any one of claims 6 to 9, wherein the transceiver unit is specifically configured to: when the plurality of data packet groups are all processed by using the generator matrix, send encoded data packets corresponding to the plurality of data packet groups to the receiving end.

11. A computer device, comprising a processor, wherein the processor is coupled to a memory; and the processor is configured to execute instructions stored in the memory, to enable the computer device to perform the method according to any one of claims 1 to 5.

12. A computer-readable storage medium, wherein the computer-readable storage medium stores instructions, and when the instructions are executed by a processor, the method according to any one of claims 1 to 5 is implemented.

13. A computer program product, wherein the computer program product comprises computer program code, and when the computer program code is run on a computer, the method according to any one of claims 1 to 5 is implemented.

11

12

| Transmitting end | Receiving end |

FIG. 1

**Opt1: NC is deployed at PDCP layers**

**Opt2: NC is separately deployed on a CU**

**Opt3: NC is separately deployed on a DU**

**Opt4: NC is deployed at RLC layers**

FIG. 2

| Transmitting end | Receiving end |
|---|---|

301: Obtain a data packet group in to-be-sent data packets

302: Process the data packets based on a generator matrix of cyclic shift network coding, to generate encoded data packets

303: Encoded data packets

FIG. 3

Group to-be-sent data packets into a plurality of data packet groups — 401

Select a data packet group to process data packets based on a generator matrix of cyclic shift network coding, to generate encoded data packets — 402

Determine whether all the to-be-sent data packets have been processed — 403 — No

Yes

Send the encoded data packets to a receiving end — 404

When a retransmission request is received, retransmit a corresponding encoded data packet based on a retransmission sequence number — 405

FIG. 4

50

Apparatus

Processing unit 501

Transceiver unit 502

FIG. 5

60

602

Communication interface

601

Processor

604

603

Storage system

FIG. 6

## INTERNATIONAL SEARCH REPORT

| International application No. |
|---|
| **PCT/CN2023/077792** |

### A. CLASSIFICATION OF SUBJECT MATTER

H04L1/00(2006.01)i

According to International Patent Classification (IPC) or to both national classification and IPC

### B. FIELDS SEARCHED

Minimum documentation searched (classification system followed by classification symbols)

IPC: H04L

Documentation searched other than minimum documentation to the extent that such documents are included in the fields searched

Electronic data base consulted during the international search (name of data base and, where practicable, search terms used)

CNTXT; ENTXTC; WPABSC; VEN; ENTXT; CNKI; 3GPP; IEEE: 循环移位, 生成矩阵, 二元, 伽罗华域, 转换, 复杂度, cycle shift, generation matrix, binary, Galois Field, convert, complexity

### C. DOCUMENTS CONSIDERED TO BE RELEVANT

| Category* | Citation of document, with indication, where appropriate, of the relevant passages | Relevant to claim No. |
|---|---|---|
| Y | CN 107302420 A (UNIVERSITY OF SCIENCE AND TECHNOLOGY BEIJING) 27 October 2017 (2017-10-27)<br>description, paragraphs [0040]-[0076] | 1-13 |
| Y | CN 110557224 A (CHINA SOUTHERN POWER GRID DIGITAL POWER GRID RESEARCH INSTITUTE CO., LTD.) 10 December 2019 (2019-12-10)<br>description, paragraph [0029] | 1-13 |
| A | CN 112600647 A (XIDIAN UNIVERSITY) 02 April 2021 (2021-04-02)<br>entire document | 1-13 |
| A | CN 101630999 A (SPACE STAR TECHNOLOGY CO., LTD.) 20 January 2010 (2010-01-20)<br>entire document | 1-13 |
| A | CN 101796488 A (TECHNOLOGY FROM IDEAS LTD.) 04 August 2010 (2010-08-04)<br>entire document | 1-13 |
| A | US 2013229991 A1 (TEXAS INSTRUMENTS INCORPORATED) 05 September 2013 (2013-09-05)<br>entire document | 1-13 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **29 May 2023** | **10 June 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
**Information on patent family members**

International application No.

**PCT/CN2023/077792**

| Patent document cited in search report | | | Publication date (day/month/year) | Patent family member(s) | | | Publication date (day/month/year) |
|---|---|---|---|---|---|---|---|
| CN | 107302420 | A | 27 October 2017 | None | | | |
| CN | 110557224 | A | 10 December 2019 | None | | | |
| CN | 112600647 | A | 02 April 2021 | None | | | |
| CN | 101630999 | A | 20 January 2010 | CN | 101630999 | B | 22 August 2012 |
| CN | 101796488 | A | 04 August 2010 | WO | 2009004601 | A2 | 08 January 2009 |
| | | | | WO | 2009004601 | A3 | 25 June 2009 |
| | | | | WO | 2009004601 | A9 | 25 March 2010 |
| | | | | EP | 2176758 | A2 | 21 April 2010 |
| | | | | EP | 2176758 | B1 | 10 November 2010 |
| | | | | JP | 2010532129 | A | 30 September 2010 |
| | | | | DE | 602008003456 | D1 | 23 December 2010 |
| | | | | US | 2009019333 | A1 | 15 January 2009 |
| US | 2013229991 | A1 | 05 September 2013 | US | 9113470 | B2 | 18 August 2015 |

Form PCT/ISA/210 (patent family annex) (July 2022)

**EP 4 462 704 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210247591